Europäisches Patentamt

European Patent Office

Office européen des brevets

(19)

(11) Numéro de publication: **0 341 122**
**A1**

## (12) DEMANDE DE BREVET EUROPEEN

(21) Numéro de dépôt: **89401129.5**

(22) Date de dépôt: **21.04.89**

(51) Int. Cl.⁴: **H 04 N 3/15**
**H 01 L 27/14**

(30) Priorité: **03.05.88 FR 8805904**

(43) Date de publication de la demande:
**08.11.89 Bulletin 89/45**

(84) Etats contractants désignés: **DE FR GB NL**

(71) Demandeur: **THOMSON-CSF**
**51, Esplanade du Général de Gaulle**
**F-92800 Puteaux (FR)**

(72) Inventeur: **Chautemps, Jacques**
**THOMSON-CSF SCPI - CEDEX 6**
**F-92045 Paris la Défense (FR)**

**Vidal, André**
**THOMSON-CSF SCPI - CEDEX 6**
**F-92045 Paris la Défense (FR)**

(74) Mandataire: **Guérin, Michel et al**
**THOMSON-CSF SCPI**
**F-92045 PARIS LA DEFENSE CEDEX 67 (FR)**

(54) Photodétecteur matriciel à transfert de charges avec dispositif intégré de filtrage de charges.

(57) Un photodétecteur matriciel comprend au bas de la zone mémoire une zone auxiliaire (110) possédant une région (D) implantée de type opposé à celui du substrat, parallèle aux canaux de transfert (CT) et suivie d'une région de passage des charges (RP) située en prolongement des canaux de transfert et surmontée d'une grille auxiliaire (GA) propre à recevoir des signaux auxiliaires de commande bas ou haut pour appliquer à la région de passage des niveaux de potentiel auxiliaires bas (PRP0) ou haut (PRP1), respectivement inférieurs en valeur absolue aux niveaux des potentiels bas (PGd0) ou haut (PGd1) produits par les autres grilles (GTa,GTd,GL), ce qui permet d'effectuer un premier filtrage des charges avant leur transfert dans le registre de lecture (20), en évacuant les charges inutiles dans un dispositif anti-éblouissement notamment du type à zone isolante.

FIG. 7

FIG. 8

FIG. 9

FIG. 10

Bundesdruckerei Berlin

# Description

## Photodétecteur matriciel à transfert de charges avec dispositif intégré de filtrage de charges.

L'invention concerne les photodétecteurs matriciels à transfert de charges du type comportant des moyens de filtrage pour ne délivrer en sortie que des charges utiles correspondant à une portion utile d'un rayonnement lumineux incident.

Les photodétecteurs sont utilisés en principe pour stocker, transférer et délivrer en sortie des charges en fonction du rayonnement lumineux incident auquel ils sont soumis et ce, afin de restituer une image numérique. Parmi les photodétecteurs, on distingue ceux qui comportent en général une seule rangée (ou barrette) d'éléments photosensibles et ceux, surfaciques ou matriciels, organisés soit en transfert de trame, soit en transfert interligne et qui sont consitués par des ensembles de canaux de transfert de charge parallèles. L'invention ne concerne que les photodétecteurs matriciels.

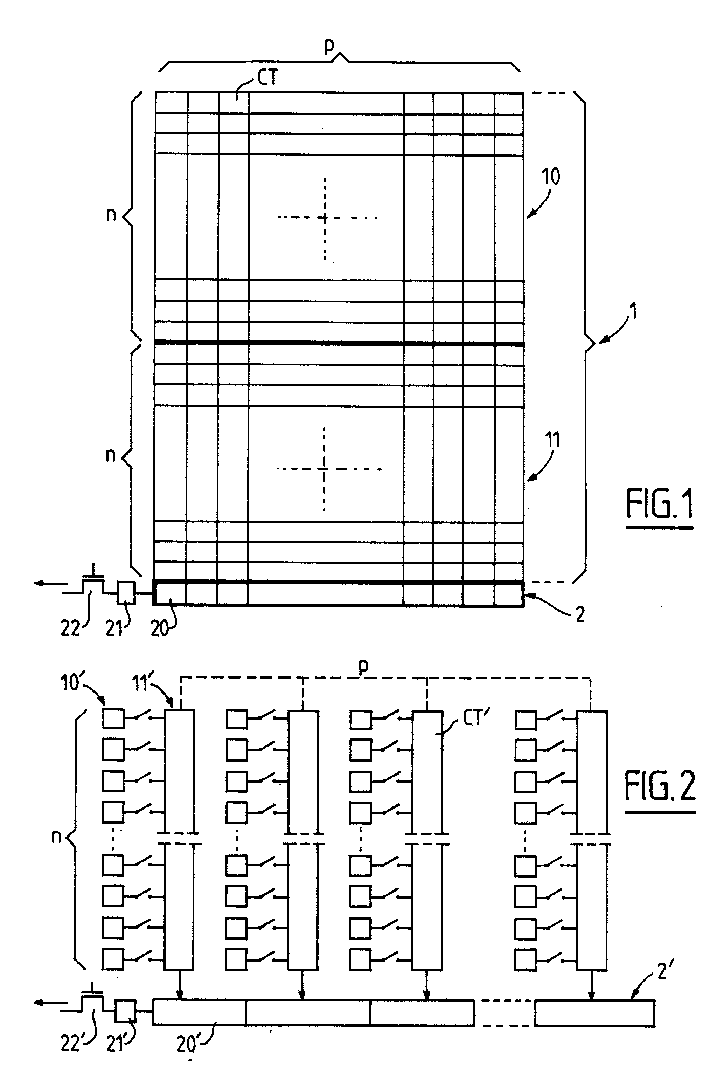

La figure 1 représente, de façon schématique, un photodétecteur matriciel classique organisé en transfert de trame. Ce photodétecteur 1 comporte une première zone 1 comprenant une sous-zone photosensible 10, communément appelée zone image et une sous-zone 11, non photosensible, communément appelée zone mémoire. Le photodétecteur 1 comprend également une deuxième zone 2 reliée à la première zone 1 comprenant un registre de lecture 20, prolongé par une diode de lecture 21 reliée à un transistor de commande 22.

La zone image 10 est une matrice comportant n lignes et p colonnes. Chaque colonne est un registre à décalage à transfert de charges vertical constituant un canal de transfert de charges. Les cases du registre sont photo sensibles et des charges s'y accumulent en fonction de l'éclairement de la case. La zone mémoire est constituée de façon identique à la zone image mais mais les cases des différents registres ne sont pas photosensibles. Le registre de lecture est un registre à décalage horizontal.

Les zones image et mémoire comprennent également des grilles de transfert surmontant les canaux de transfert et propres à recevoir des signaux de commande bas ou haut pour appliquer aux canaux de transfert un niveau de potentiel bas ou haut de façon à y permettre le transfert de charges. Le registre de lecture est propre à recevoir au moins une partie des charges emmagasinées dans la zone mémoire et est surmonté d'une grille de lecture propre à recevoir également des signaux de commande bas ou hauts pour appliquer au registre de lecture un niveau de potentiel bas ou haut, de façon à permettre le transfert des charges contenues dans ce registre de lecture dans la diode de lecture.

La figure 2 illustre de façon schématique un photodétecteur matriciel organisé en transfert interligne. La zone image 10' est constituée par des colonnes de photodiodes interconnectées avec des colonnes de cases photosensibles appartenant à des registres à décalage vertical constituant la zone mémoire 11'. La partie basse de chaque canal de transfert CT' est reliée à une case d'un registre à décalage horizontal constituant le registre de lecture 20'.

Le principe de fonctionnement d'un photodétecteur matriciel organisé en transfert de trame est maintenant décrit sommairement. Pendant un temps d'intégration, des charges correspondant à l'image lumineuse reçue sont emmagasinées dans les registres de la zone image 10. Lorsque ce temps d'intégration est écoulé, l'image complète emmagasinée dans la zone image 10 est transférée pendant un temp dit de transfert dans la zone mémoire 11, ligne par ligne, par un décalage vertical. Pendant le temps d'intégration suivant, alors que l'image suivante est stockée dans la zone image, l'image stockée dans la zone mémoire est transférée, ligne par ligne, dans le registre de lecture par décalage vertical et chaque ligne est transférée du registre de lecture dans la diode de lecture à l'aide d'un décalage horizontal, puis de la diode de lecture vers la sortie.

Le principe de fonctionnement d'un photodétecteur organisé en transfert interligne est sensiblement analogue. Les charges emmagasinées dans les photodiodes sont transférées horizontalement vers les registres à décalage puis chaque ligne des registres à décalage est décalée verticalement dans le registre de lecture et transférée dans la duide de lecture par un décalage horizontal de ce dernier.

Dans de nombreux cas de prises de vue, seule une partie de l'image est réellement utile à un moment donné. Par exemple, lors du suivi d'un objet, une fois le repérage de cet objet effectué, son suivi ne demande qu'une faible résolution mais une cadence de renouvellement de l'image élevée.

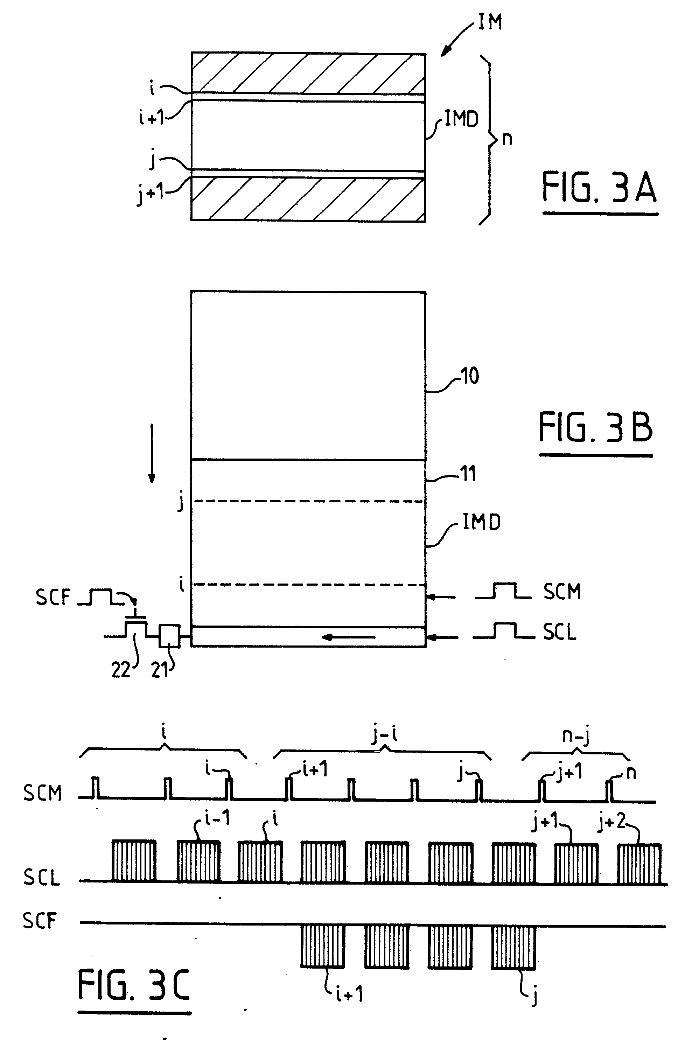

Les figures 3A à 3C illustrent schématiquement un principe de filtrage actuellement utilisé dans l'état de la technique pour ne délivrer en sortie que des charges utiles correspondant à ladite portion utile IMD du rayonnement lumineux incident IM, c'est-à-dire à la portion de l'image que l'on souhaite visualiser. La figure 3A représente l'image désirée IMD. Sur les n lignes de l'image totale IM, on souhaite éliminer les lignes 1 à i, ainsi que les lignes j + 1 à n, pour ne visualiser que les lignes i + 1 à j. Sur la figure 3B, l'image totale IM, comprenant l'image désirée IMD, est représentée déjà transférée dans la zone mémoire 11. Sous l'action du signal de commande SCM, bas ou haut, appliquée aux différentes grilles de transfert de la zone mémoire, chaque ligne de cette zone mémoire est transférée dans le registre de lecture. Ce dernier, sous l'action du signal de commande SCL, bas ou haut, appliqué à la grille de lecture, transfère la ligne qu'il contient dans la diode de lecture. Cette ligne est ensuite, effectivement ou non, délivrée en sortie sous le contrôle du signal de commande de filtrage SCF qui est, en fait, une horloge de commande de la grille du transistor de commande. Ainsi, lorsque le signal de commande SCF présente un changement d'état (haut/bas ou l'inverse) pendant l'action de signal de commande SCL, la ligne présente dans le registre de lecture est effectivement transférée dans la diode de lecture puis délivrée en sortie, tandis que, quand le signal de commande SCF est l'état haut, la diode de lecture est remise à 0 et aucune ligne n'est délivrée. Le transistor de commande 22 et le signal de commande SCF font donc partie de moyens de filtrage.

Un chronogramme de la restitution de l'image, présente dans la zone mémoire, est illustré sur la figure 3C. Pour l'explication de ce chronogramme, le registre de lecture est supposé n'avoir qu'une seule ligne. Lors des i premières impulsions du signal de commande SCM, les i premières lignes de l'image IM sont successivement transférées dans le registre de lecture 2. Celui-ci, sous l'action des i premières impulsions du signal de commande SCL, libère ces lignes. Le signal de commande SCF étant, pendant ce temps, constamment à l'état haut, aucune de ces lignes n'est effectivement délivrée en sortie du photodétecteur. On a donc éliminé les charges inutiles correspondant aux lignes 1 à i de l'image. Lors des impulsions i + 1 à j du signal de commande SCM, ces lignes correspondantes sont transférées dans le registre de lecture qui, sous l'action des impulsions i + 1 à j correspondantes du signal de commande SCL, libère les lignes correspondantes vers l'extérieur. Puisque, pendant le même temps, le signal de commande SCF présente un changement d'état pendant le transfert d'une ligne hors du registre de lecture, ces lignes sont effectivement délivrées en sortie du photodétecteur et l'on restitue les lignes i + 1 à j de l'image désirée. Lors des impulsions j + 1 à n des signaux de commande SCM et SCL, le signal de commande SCF est maintenu à l'état haut et l'on élimine ainsi les charges inutiles des lignes j à n. Le processus se répète pour l'image suivante. On remarque immédiatement que la vitesse de scrutation de l'image est liée à la rapidité d'évacuation des lignes inutiles par le registre de lecture. Actuellement, pour augmenter cette cadence, on somme dans le registre de lecture plusieurs lignes à la fois. Cependant, cette efficacité est limitée par la taille du registre de lecture, selon qu'il peut contenir 2 ou n lignes simultanément. Le maximum de lignes que peut contenir un registre de lecture se situe entre 4 et 8 lignes car, au-delà, celui-ci devient trop grand et la fréquence de lecture risque de se détériorer. La cadence d'informations est donc limitée par la taille de ce registre de lecture et ceci est pénalisant pour des récurrences d'informations très élevées.

La présente invention remédie à ces inconvénients en proposant un photodétecteur matriciel muni de moyens de filtrage des charges utiles ne nécessitant pas un surdimensionnement du registre de lecture et autorisant une cadence de scrutation de l'image très élevée.

L'invention a donc pour objet un photodétecteur matriciel à transfert de charge du type comportant :
- une première zone, en partie photosensible, dans laquelle sont emmagasinées lesdites charges et comprenant, sur un substrat semi-conducteur :
. une pluralité de canaux de transfert de charge parallèle,
. des grilles de transfert surmontant les canaux de transfert et propres à recevoir des signaux de commande bas ou haut pour appliquer aux canaux de transfert un niveau de potentiel bas ou haut, de façon à y permettre le transfert de charge,
- une deuxième zone, reliée à la première zone, propre à recevoir au moins une partie des charges emmagasinées dans la première zone, et comprenant
. un registre de lecture prolongé par une diode de lecture,
. une grille de lecture surmontant le registre de lecture et propre à recevoir des signaux de commande bas ou haut pour appliquer au registre de lecture un niveau de potentiel bas ou haut, de façon à permettre le transfert des charges contenues dans le registre de lecture dans la diode de lecture, et,
. des moyens de filtrage agissant sur la diode de lecture pour ne délivrer en sortie que des charges utiles correspondant à une portion utile du rayonnement lumineux incident,
caractérisé en ce que les moyens de filtrage comprennent, dans la première zone, une zone auxiliaire comportant une région implantée de type opposé à celui du substrat, parallèle aux canaux de transfert et suivie d'une région de passage des charges, située dans le prolongement des canaux de transfert, et surmontée d'une grille auxiliaire propre à recevoir des signaux auxiliaires de commande bas ou haut, pour appliquer à la région de passage des niveaux de potentiel auxiliaires bas ou haut, respectivement inférieurs en valeur absolue aux niveaux de potentiel bas ou hauts produits par les autres grilles, ce qui permet d'effectuer un premier filtrage des charges avant leur transfert dans le registre de lecture.

Dans un mode préféré de réalisation, la zone auxiliaire comprend un dispositif anti-éblouissement du type à zone isolante, c'est-à-dire du type de celui décrit dans la Demande de Brevet français n° 82-11395, au nom de la Demanderesse.

Dans un premier mode de réalisation, la région de passage comprend une portion implantée de type identique à celui du substrat et les signaux de commande bas ou haut sont alors respectivement identiques en amplitude aux signaux de commande bas ou haut des autres grilles.

Dans un autre mode de réalisation, les signaux de commande auxiliaires bas ou haut ont des amplitudes différentes de celles respectives des autres signaux de commande bas ou haut.

Selon une variante de l'invention, le photodétecteur est du type à transfert de trame et la zone auxiliaire est située au bas de la zone image.

Dans une autre variante de l'invention, le photodétecteur est du type à transfert de trame et la zone auxiliaire est située à la fin de la zone mémoire.

Le photodétecteur peut être également du type à transfert interligne et la zone auxiliaire est alors située au bas de la zone mémoire.

De façon très avantageuse, le photodétecteur selon l'invention peut être équipé d'au moins un autre dispositif anti-éblouissement du type à zone isolante situé dans la partie photosensible de la première zone.

D'autres avantages et caractéristiques de l'invention apparaîtront à l'examen de la description détaillée ci-après et des dessins annexés sur lesquels :

- la figure 1, déjà décrite, illustrant l'état de la technique, est une représentation schématique d'un photodétecteur matriciel classique à transfert de trame,

- la figure 2, déjà décrite, illustrant l'état de la technique, est une représentation schématique d'un photodétecteur matriciel classique à transfert interligne,

- les figures 3A à 3C, déjà décrites, illustrent de façon schématique le principe de fonctionnement d'un photodétecteur matriciel à transfert de trame de l'état de la technique du type comportant des moyens de filtrage pour ne délivrer en sortie que des charges utiles correspondant à une portion utile du rayonnement lumineux incident,

- la figure 4 est une illustration schématique d'un premier mode de réalisation d'un photodétecteur selon l'invention,

- la figure 5 est une illustration schématique d'un deuxième mode de réalisation du photodétecteur selon l'invention,

- la figure 6 est une illustration schématique d'un troisième mode de réalisation d'un photodétecteur selon l'invention,

- la figure 7 est une représentation schématique du bas de la zone mémoire du photodétecteur de la figure 5,

- la figure 8 est la coupe VIII-VIII de la figure 7,

- la figure 9 est la coupe IX-IX de la figure 7,

- la figure 10 est la coupe X-X de la figure 7,

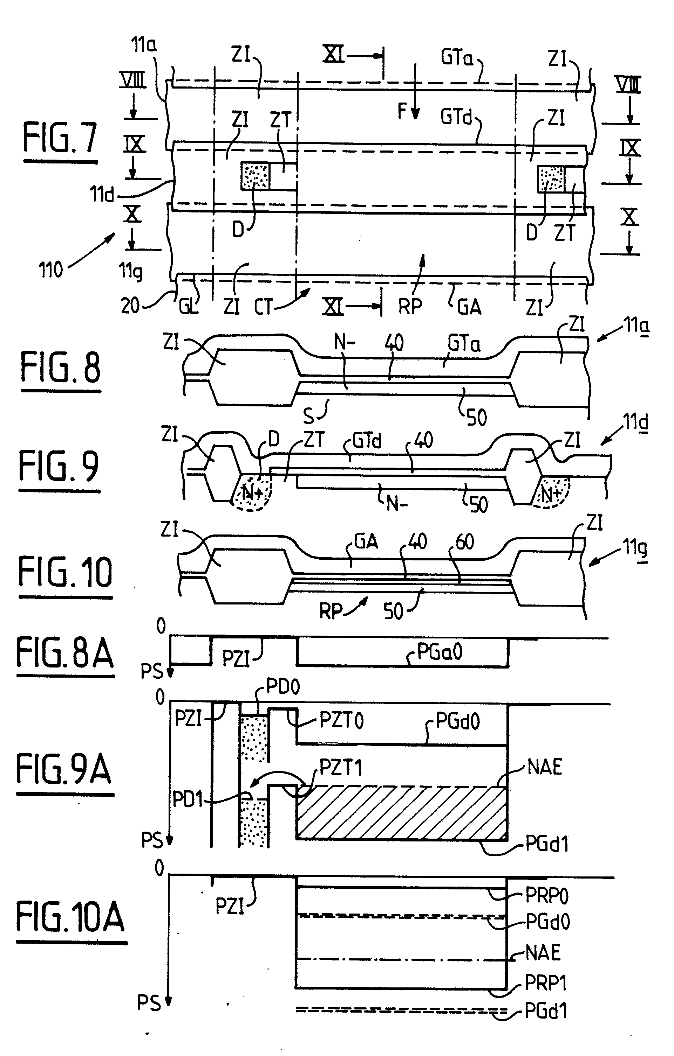

- la figure 8A est un diagramme schématique illustrant les variations du potentiel de surface des différents constituants du photodétecteur représentés sur la figure 8,

- la figure 9A est un diagramme schématique illustrant les potentiels de surface des différents constituants du photodétecteur représentés sur la figure 9,

- la figure 10A est un diagramme schématique illustrant les variations du potentiel de surface des différents constituants du photodétecteur représentés sur la figure 10,

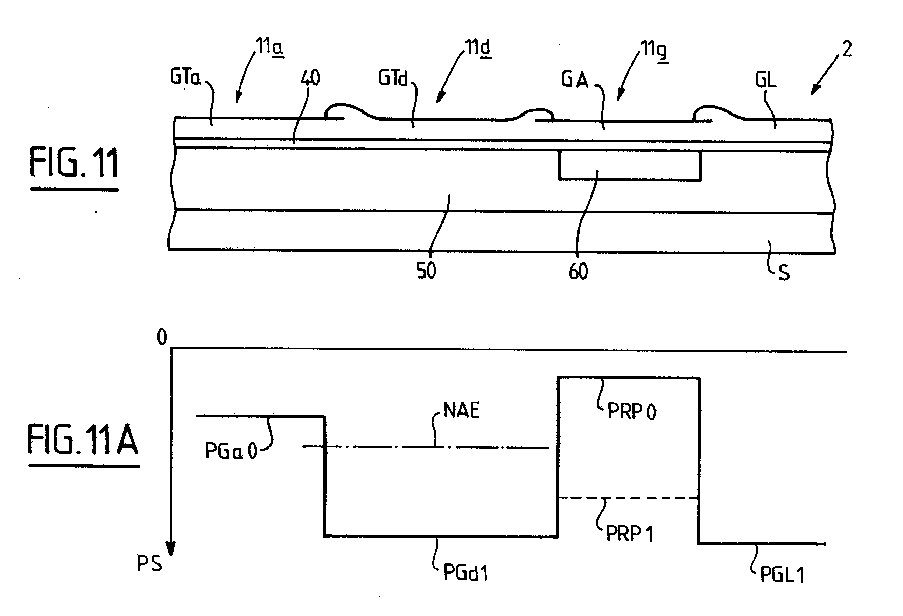

- la figure 11 est la coupe XI-XI de la figure 7,

- la figure 11A est un diagramme schématique illustrant les variations du potentiel de surface des différents constituants du photodétecteur représentés sur la figure 11 et,

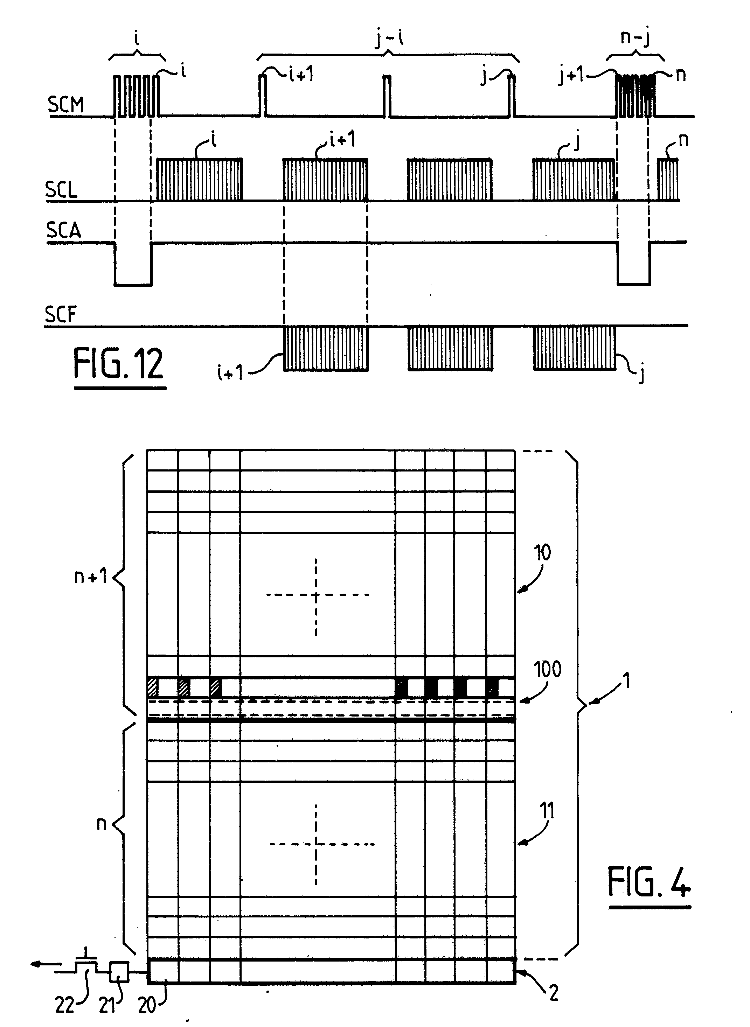

- la figure 12 est un chronogramme schématique illustrant le principe de fonctionnement d'un photodétecteur selon l'invention.

Les dessins, comportant pour l'essentiel des éléments de caractère certain, font partie intégrante de la description. Il en est de même pour la Demande de Brevet français n° 82-11395, au nom de la Demanderesse, ainsi que pour tous les documents cités dans cette Demande de Brevet français n° 82-11395.

A ce titre, les dessins annexés, ainsi que la Demande de Brevet français n° 82-11395 et les documents qui y sont cités, pourront servir non seulement à mieux faire comprendre la description détaillée ci-après, mais aussi contribuer, le cas échéant, à la définition de l'invention.

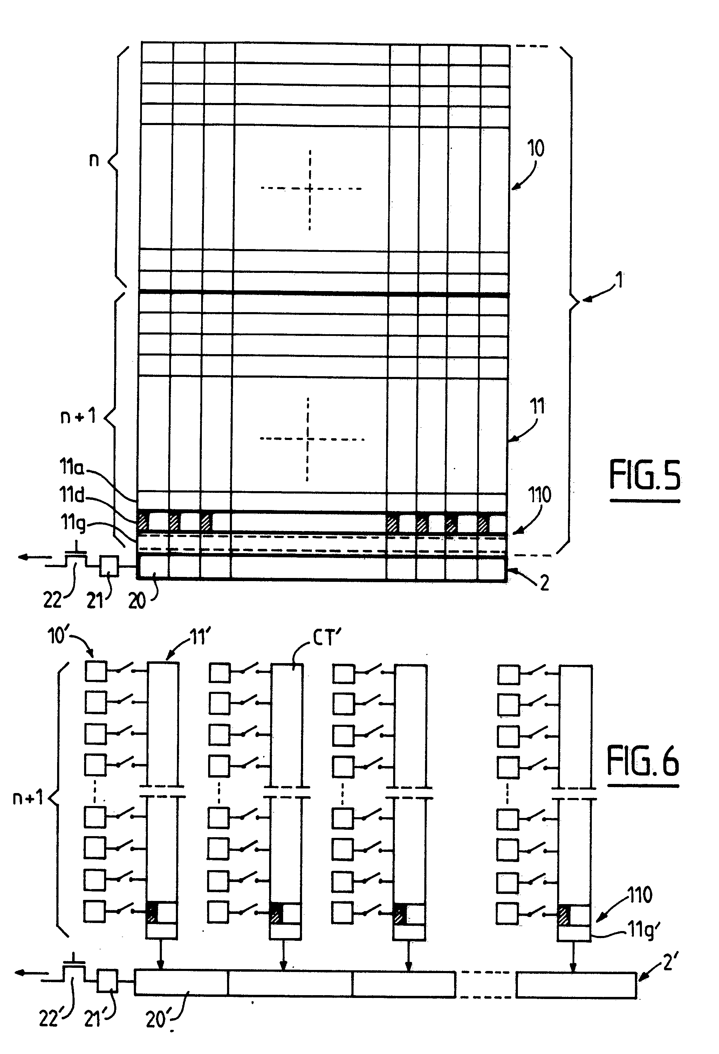

La figure 4 représente, de façon schématique, un premier mode de réalisation du photodétecteur selon l'invention. Dans ce premier mode de réalisation, le photodétecteur est du type matriciel à transfert de trame et l'on voit que la zone image 10 comprend n+1 lignes, soit une ligne de plus que dans un photodétecteur classique de l'art antérieur. De plus, la nème ligne de la zone image, c'est-à-dire l'avant-dernière ligne, comporte des régions implantées de type opposé à celui du substrat, parallèles aux canaux de transfert. Ces régions implantées, ainsi que la ligne supplémentaire n+1, font partie d'une zone auxiliaire 100 qui sera détaillée ci-après, et qui est donc située au bas de la zone image.

La figure 5 représente, de façon schématique, un deuxième mode de réalisation du photodétecteur matriciel à transfert de trame. Sur cette figure, la zone mémoire 11 comprend n-1 lignes, c'est-à-dire une ligne de plus que dans un photodétecteur de l'art antérieur. La zone auxiliaire 110 est analogue à la zone auxiliaire 100 et est située sur les lignes n et n+1 de la zone mémoire 11, respectivement référencées 11d et 11g, c'est-à-dire au bas de la zone mémoire.

La figure 6 représente, de façon schématique, un troisième mode de réalisation d'un photodétecteur selon l'invention dans le cas où celui-ci est du type à transfert interligne. Dans ce cas, les canaux de transfert CT' de la zone de mémoire 11' comportent n+1 cases, et l'on définit une zone auxiliaire 110' analogue aux zones auxiliaires 100 et 110, située au bas de la zone mémoire.

On fait maintenant référence aux figures 7 à 10 pour décrire, de façon détaillée, la structure d'une zone auxiliaire 110, située au bas de la zone mémoire 11, dans le cas d'un photodétecteur matriciel à transfert de trame. On a donc représenté sur les figures 7 à 10, de façon plus précise, les lignes n-1, n et n+1 de la zone mémoire 11, respectivement référencées 11a, 11d et 11g.

Le photodétecteur à transfert de charge comporte un susbstrat semi-conducteur S tel que du silicium de type P, par exemple, recouvert au moins en partie d'une couche d'isolant 40, réalisée par exemple en oxyde de silicium. Sur la figure 7, on a représenté un canal de transfert CT dans lequel les charges sont susceptibles d'être transférées longitudinalement dans le sens de la flèche F. Chacune des lignes du photodétecteur matriciel comporte des grilles de transfert telles que GTa et GTd, recouvrant le canal de transfert CT et disposées sensiblement perpendiculairement à la direction du transfert des charges. L'ensemble (grille - couche d'isolant - substrat) définit dans le canal de transfert CT des condensateurs du type à couplage de charge.

La portion de canal de transfert, située sur la ligne 11d comprend un dispositif anti-éblouissement du type de celui décrit dans la Demande de Brevet français n° 82-11395. Ce dispositif anti-éblouissement sera désigné par la suite sous la dénomination "dispositif anti-éblouissement du type à zone isolante". On en rappellera ci-après les principaux éléments constitutifs ainsi que les principaux principes de fonctionnement, l'homme de l'art pouvant se référer à la Demande de Brevet français n° 82-11395 précitée pour plus de détails.

Le canal de transfert CT comprend, dans le cas où le transfert des charges se fait en volume, une implantation d'impuretés 50 de type opposé à celui du substrat qui occupe toute la largeur de ce canal CT. Le dispositif anti-éblouissement du type à zone isolante est situé entre deux canaux de transfert adjacents. Ce dispositif comprend une diode D formée par une région implantée de type opposé à celui du substrat c'est-à-dire de type N et parallèle au canal de transfert CT. Ce dispositif comprend également une zone de transition ZT assurant une diminution du potentiel de surface du substrat, le potentiel de surface de cette zone de transition ZT variant en fonction du potentiel appliqué sur la grille GTd. La diode D et la zone de transfert ZT sont entourées de tous côtés, à l'exception de celui contigu au canal de transfert CT, par une zone isolante ZI, telle que le potentiel de surface dans le substrat, sous cette zone isolante, soit nul et invariable en fonction des tensions appliquées sur les grilles GTd ainsi que sur les grilles adjacentes. A titre d'exemple, cette zone isolante ZI peut être réalisée par une implantation d'impuretés du même type que celle du substrat avec une concentration d'impuretés supérieure à $10^{19}$ atomes/cm$^3$, ou bien par un dépôt d'isolant tel que l'oxyde de silicium sous une épaisseur de 1 micron, environ. Cette zone isolante ZI se prolonge sur la ligne 11a pour être contiguë à la portion de canal de transfert CT recouverte de la grille GTa.

La ligne supplémentaire 11g comporte une portion de canal de transfert possédant entre la diffusion d'impuretés 50 et la zone d'isolant 40 une diffusion d'impuretés 60 de type opposé à la diffusion d'impuretés 50, donc de même type que celle du substrat c'est-à-dire de type P. Cette portion de canal de transfert constitue une région de passage RP pour les charges transitant de la zone mémoire 11 vers le registre de lecture 20. Cette région de transfert RP prolonge donc le canal CT dans la zone mémoire 11. La ligne 11g comprend également le prolongement de la zone isolante ZI parallèlement à la région de passage RP. Ainsi, la zone auxiliaire 110 comprend-elle le dispositif anti-éblouissement du type à zone isolante comportant la diode D, la zone de transition ZT et la zone isolante ZI, ainsi que la région de passage RP recouverte d'une grille auxiliaire GA du même type que les grilles de transfert GTa et GTd. Cette grille auxiliaire GA est commandée de façon indépendante des autres grilles de transfert et de la grille de lecture GL.

Les figures 8A à 10A illustrent, de façon schématique, l'évolution des potentiels de surface PS des différentes régions du substrat. D'une façon générale, chaque grille est commandée par un signal de commande bas ou haut qui confère à la zone située sous la grille un niveau de potentiel bas ou haut. La référence du niveau de potentiel d'une zone sera affectée du suffixe 0 pour un niveau de potentiel bas et du suffixe 1 pour un niveau de potentiel haut.

Ainsi, le niveau du potentiel bas de la portion de canal de transfert, située sous la grille de transfert GTa, sera affectée de la référence PGa0.

Les figures 8A, 9A et 10A montrent que le potentiel de surface PZI, dans la zone isolante ZI, est nul et invariable en fonction des potentiels appliqués sur les différentes grilles. La première partie de la figure 9A montre l'évolution du potentiel de surface PS lorsque la grille de transfert GTd est activée par le signal de commande bas et la deuxième partie de cette même figure 9A montre l'évolution des potentiels de surface lorsque la grille de transfert GTd est activé par le signal de commande O. Dans ce dernier cas, lorsqu'il y a accumulation de charge et dépassement du niveau anti-éblouissement NAE, il y a évacuation des charges en excès vers le puits de potentiel formé par la diode D. Il est à noter que le niveau du potentiel haut PZT1, de la zone de transfert, doit être supérieur au niveau de potentiel bas PGd0, afin que les charges en excès aillent de préférence vers la diode D au lieu de déborder dans le sens du transfert vers les autres puits de potentiel.

La figure 10A illustre l'évolution du potentiel de surface sous la grille auxiliaire GA, celle-ci étant soumise à un signal de commande auxiliaire bas ou haut. Dans une première variante de l'invention, les signaux de commande auxiliaire de la grille auxiliaire GA sont identiques en amplitude aux signaux de commande des grilles de transfert et de lecture mais la compensation provoquée par la diffusion de la zone d'impuretés 60 provoque un niveau de potentiel PRP dans la zone de passage RP différent des niveaux de potentiel dans le reste du canal de transfert. Ainsi, lorsque la grille auxiliaire est activée par le signal de commande auxiliaire à l'état bas, le potentiel de surface PRP0 de la région de passage est inférieur au potentiel PGd0 et lorsque la grille auxiliaire est activée par le signal de commande auxiliaire à l'état haut, le niveau de potentiel haut PRP1 de la région de passage est inférieur aux niveaux de potentiel PGd1 mais supérieur au niveau anti-éblouissement NAE.

La figure 11 illustre de façon schématique une coupe longitudinale des lignes 11a, 11d et 11g ainsi que du registre de lecture 20, cette coupe montrant l'implantation d'impuretés 60 de même type que le substrat.

La figure 11A montre l'évolution du potentiel de surface correspondant à la coupe de la figure 11, dans un cas particulier de fonctionnement. On suppose, dans ce cas, que la grille de transfert GTa est activée par le signal de commande à l'état bas, que la grille de transfert GTd est activée par le signal de commande à l'état haut, de même que pour la grille de lecture GL, tandis que la grille auxiliaire est activée par le signal de commande auxiliaire à l'état bas.

On retrouve donc sur cette figure 11A le positionnement des différents niveaux de potentiel les uns par rapport aux autres.

Dans une autre variante, selon l'invention, les signaux de commande auxiliaires de la grille auxiliaire GA peuvent être différents en amplitude par rapport aux signaux de commande des autres grilles, de façon à appliquer à la grille auxiliaire une tension inférieure à celle des autres grilles pour respecter l'échelle des niveaux de potentiel.

Les figures 11A et 12 vont maintenant servir à illustrer le principe de fonctionnement du photodétecteur selon l'invention.

Sur la figure 12, la référence SCM désigne le signal de commande appliqué aux différentes grilles de transfert de la zone mémoire, la référence SCL désigne le signal de commande appliqué à la grille de lecture GL, la référence SCA désigne le signal de commande auxiliaire appliqué à la grille auxiliaire, tandis que la référence SCF désigne le signal de commande de filtrage appliqué sur le transistor de commande 22.

On souhaite toujours obtenir en sortie du photodétecteur une image numérique IMD constituée par les lignes i+1 à j. Aussi, pendant les i premières impulsions du signal de commande SCM, le signal de commande auxiliaire SCA est bas appliquant à la région de passage RP un niveau de potentiel bas PRP0. Les charges correspondant aux lignes 1 à i-1 viennent alors "s'accumuler" contre la barrière de potentiel formée sous la grille GA et lorsque le niveau de ces charges dépasse le niveau anti-éblouissement NAE, les charges excédentaires, donc des charges inutiles, sont éliminées par le dispositif anti-éblouissement du type à zone isolante. Lors de l'impulsion i du signal SCM, le signal de commande SCA est haut ainsi que le signal de commande de la grille de lecture SCL. Ceci est également vrai pour les impulsions i+1 à j. Les charges inutiles correspondant à la ligne i sont alors transférées dans le registre de lecture puis dans la diode de lecture et sont éliminées à l'aide du signal de commande SCF haut. Les autres charges correspondant aux lignes i+1 à j, donc les charges utiles, sont effectivement délivrées en sortie pour restituer l'image désirée IMP. Une disposition identique à celle utilisée pour les impulsions 1 à i est utilisée pour les impulsions j+1 à n, les impulsions j+1 à n-1 étant évacuées par le dispositif anti-éblouissement du type à zone isolante tandis que l'impulsion n est évacuée à l'aide du signal de commande de filtrage SCF.

L'homme de l'art comprendra donc que c'est la combinaison du dispositif anti-éblouissement du type à zone isolante et de la ligne supplémentaire 11g munie de la grille auxiliaire GA qui permet un premier filtrage des charges utiles avant leur transfert dans le registre de lecture. Ainsi, ce dernier n'a pas besoin d'être surdimensionné puisqu'il n'évacue au maximum qu'une seule ligne inutile. De plus, le nombre de sommations de lignes inutiles est illimité et plus le nombre de lignes est faible, plus le temps de récurrence entre deux images devient faible.

On a décrit ci-avant une zone auxiliaire située au bas de la zone de mémoire car cette disposition est plus intéressante qu'une disposition d'une zone auxiliaire placée à la fin de la zone image car on peut agir directement sur l'information qui va sortir alors qu'une disposition à la fin de la zone image ne permet d'agir que sur l'information qui sortira une période image après.

Bien entendu, une zone auxiliaire 110', placée au bas de la zone mémoire dans le cas d'un photodétecteur matriciel à transfert interligne fonctionnerait de façon identique.

Bien que l'utilisation dans la zone auxiliaire d'un dispositif anti-éblouissement du type à zone isolante soit particulièrement avantageuse, il n'est pas nécessaire d'utiliser un tel dispositif anti-éblouissement. Il suffirait simplement que la zone auxiliaire comporte, outre la région de passage surmontée de la grille auxiliaire, une région implantée du type opposé à celui du substrat, tel qu'utilisé par exemple dans les dispositifs anti-éblouissement de l'état de la technique décrits dans la Demande de Brevet français 82-11395.

Un mode de fabrication d'un tel photodétecteur selon l'invention est décrit en détail dans la demande de brevet française n° 82-11395.

L'invention peut comporter des variantes, notamment les suivantes :

- l'invention a été décrite en utilisant un substrat au silicium de type P mais il est évident pour l'homme de l'art qu'elle ne se limite pas à ce type de substrat ni au type d'impuretés utilisés. Toutefois, dans le cas d'un substrat de type N, les signes des charges et des potentiels seront inversés par rapport au substrat de type P décrit ci-dessus, la zone de transfert ZT assurant alors un accroissement du potentiel de surface tandis que les niveaux de potentiel auxiliaires, bas ou haut, de la région de passage seront respectivement inférieurs en valeur absolue aux niveaux de potentiel, bas ou haut, produits par les autres grilles;

- un photodétecteur selon l'invention peut comporter dans la zone image au moins un autre dispositif anti-éblouissement du type à zone isolante, cet autre dispositif assurant alors sa fonction propre telle que décrite dans la Demande de Brevet français n° 82-11395.

Bien entendu certains des moyens décrits ci-dessus peuvent être omis dans les variantes où ils ne servent pas.

## Revendications

1. Photodétecteur matriciel à transfert de charges du type comportant :
- une première zone (1) en partie photosensible, dans laquelle sont emmagasinées lesdites charges et comprenant, sur un substrat semi-conducteur (S) :
. une pluralité de canaux de transfert de charge (CT) parallèles,
. des grilles de transfert (GTa,GTd), surmontant les canaux de transfert et propres à recevoir des signaux de commande bas ou haut (SCM) pour appliquer aux canaux de transfert un niveau de potentiel bas (PGa0,PGd0) ou haut (PGa1,PGd1), de façon à y permettre le transfert des charges,
- une deuxième zone (2), reliée à la première zone (1), propre à recevoir au moins une partie des charges emmagasinées dans la première zone, et comprenant :

. un registre de lecture (20) prolongé par une diode de lecture (21),

. une grille de lecture (GL) surmontant le registre de lecture (20) et propre à recevoir des signaux de commande bas ou haut (SCL) pour appliquer au registre de lecture (20) un niveau de potentiel bas ou haut (PGL1) de façon à permettre le transfert des charges contenues dans le registre de lecture (20) dans la diode de lecture (21), et,

. des moyens de filtrage (22,SCF) agissant sur la diode de lecture (21) pour ne délivrer en sortie que des charges utiles correspondant à une portion utile (IMD) du rayonnement lumineux incident (IM),

caractérisé en ce que les moyens de filtrage comprennent, dans la première zone (1), une zone auxiliaire (100,110,110') comportant une région (D) implantée de type opposé à celui du substrat (S), parallèle aux canaux de transfert (CT) et suivie d'une région de passage des charges (RP), située en prolongement des canaux de transfert, et surmontée d'une grille auxiliaire (GA), propre à recevoir des signaux auxiliaires de commande (SCA) bas ou haut, pour appliquer à la région de passage (RP) des niveaux de potentiel auxiliaires bas (PRP0) ou haut (PRP1), respectivement inférieurs en valeur absolue aux niveaux de potentiel bas ou haut produits par les autres grilles (GTa,GTd,GL), ce qui permet d'effectuer un premier filtrage des charges avant leur transfert dans le registre de lecture.

2. Dispositif selon la revendication 1, caractérisé en ce que la zone auxiliaire comprend un dispositif anti-éblouissement du type à zone isolante.

3. Dispositif selon l'une des revendications 1 ou 2, caractérisé en ce que la région de passage (RP) comprend une portion (60) implantée de type identique à celui du substrat (S) et en ce que les signaux de commande auxiliaires bas ou haut (SCA) sont respectivement identiques en amplitude aux signaux de commande bas ou haut des autres grilles.

4. Dispositif selon l'une des revendications 1 ou 2, caractérisé en ce que les signaux de commande auxiliaires bas ou haut (SCA) ont des amplitudes différentes de celles respectives des autres signaux de commande bas ou haut.

5. Dispositif selon l'une des revendications précédentes, caractérisé en ce qu'il est du type à transfert de trame, la première zone comprenant une première sous-zone photosensible (10) dite zone image, suivie d'une deuxième sous-zone non photosensible (11) dite zone mémoire, et en ce que ladite zone auxiliaire (100) est située au bas de la zone image (10).

6. Dispositif selon l'une des revendications 1 à 4, caractérisé en ce qu'il est du type à transfert de trame, la première zone comprenant une première sous-zone photosensible (10) dite zone image, suivie d'une deuxième sous-zone non photosensible (11), dite zone mémoire, et en ce que ladite zone auxiliaire (110) est située au bas de la zone mémoire (11).

7. Dispositif selon l'une des revendications 1 à 4, caractérisé en ce qu'il est du type à transfert interligne comprenant une première sous-zone constituée d'éléments photosensibles (10'), en particulier des photodiodes, et une deuxième sous-zone, dite zone mémoire (11') comprenant des colonnes de canaux de transfert de charge (CT') et en ce que ladite zone auxiliaire (110') est située au bas de la zone mémoire (11').

8. Dispositif selon l'une des revendications précédentes, caractérisé en ce qu'il comprend au moins un autre dispositif anti-éblouissement du type à zone isolante situé dans la partie photosensible de la première zone.

FIG.1

FIG.2

IM

i
i+1

IMD

j
j+1

n

## FIG. 3A

10

11

j

IMD

i

SCF

22  21

SCM

SCL

## FIG. 3B

SCM

i

i

i+1

j-i

j

n-j

j+1

n

SCL

i-1

i

j+1

j+2

SCF

i+1

j

## FIG. 3C

FIG.5

FIG.6

FIG.7

FIG.8

FIG.9

FIG.10

FIG.8A

FIG.9A

FIG.10A

EP 0 341 122 A1

## FIG. 11

11a  40  11d  11g  2
GTa  GTd  GA  GL

50  60  S

## FIG. 11A

0

PGa0  NAE  PRP0

PRP1

PS

PGd1  PGL1

FIG.12

FIG.4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 235 002 (SOCIETE NATIONALE INDUSTRIELLE AEROSPATIALE) * Page 4, ligne 19 - page 5, ligne 13; page 11, ligne 1 - page 12, ligne 22 * | 1,2 | H 04 N 3/15 H 01 L 27/14 |
| A | | 5 | |
| | --- | | |
| Y | EP-A-0 083 376 (SONY CORP.) * Page 15, ligne 4 - page 18, ligne 14; page 21, ligne 13 - page 22, ligne 8; figures 7,10 * | 1,2 | |
| A | | 3,5-8 | |
| | --- | | |
| A | PATENT ABSTRACTS OF JAPAN, vol. 10, no. 65 (E-388)[2122], 14 mars 1986; & JP-A-60 217 661 (TOSHIBA K.K.) 31-10-1985 | 1,7 | |
| | --- | | |
| A | EP-A-0 163 547 (FUJITSU LTD) * Page 5, ligne 17 - page 7, ligne 33; page 12, lignes 9-22 * | 1,7 | |
| | --- | | DOMAINES TECHNIQUES RECHERCHES (Int. Cl.4) |
| A | FR-A-2 548 497 (THOMSON CSF) * Page 6, lignes 3-9; page 8, lignes 4-23; figure 6 * | 1 | H 04 N 3 H 01 L 27 H 04 N 5 |
| | --- | | |
| A | IEEE 1987-SOLID STATE CIRCUITS CONFERENCE, vol. 30, 1ère édition, février 1987, pages 106-107, IEEE, New York, US; T. YAMADA et al.: "A line-address CCD image sensor" * Figures 1,4a,4b * | 1,2 | |
| | ----- | | |

Le présent rapport a été établi pour toutes les revendications

| Lieu de la recherche | Date d'achèvement de la recherche | Examinateur |
|---|---|---|
| LA HAYE | 21-06-1989 | DUHR R.H.J.E. |